# EUROPÄISCHE PATENTSCHRIFT

(11) **EP 0 532 776 B1**
(45) Veröffentlichungstag und Bekanntmachung des Hinweises auf die Patenterteilung: **23.11.1994**
(21) Anmeldenummer: 91115777.4
(22) Anmeldetag: 17.09.1991
(51) Int. Cl.: B23B 39/16, H05K 3/00

(54) **Verfahren zum Bohren von Mehrlagenleiterplatten**
Process to drill multilayered contact boards
Procédé de perçage de platines multicouches

(43) Veröffentlichungstag der Anmeldung: 24.03.1993
(73) Patentinhaber: Siemens Nixdorf Informationssysteme Aktiengesellschaft, 33102 Paderborn (DE)
(72) Erfinder: Mann, Wolfgang, W-8150 Holzkirchen (DE); Neumann, Rudolf, Dipl.-Ing., W-8930 Schwabmünchen (DE); Selbmann, Heinz-Jörg, W-8900 Augsburg 21 (DE)
(74) Vertreter: Fuchs, Franz-Josef, Dr.-Ing.

(56) Entgegenhaltungen:
- EP-A- 0 053 272
- EP-A- 0 162 290
- US-A- 3 532 893
- PATENT ABSTRACTS OF JAPAN vol. 7, no. 179 (M-234)(1324) 9. August 1983 & JP-A-58 082 612 (HITACHI SEISAKUSHO K.K.) 18 Mai 1983

## Beschreibung

Die Erfindung betrifft ein Verfahren zum Bohren von mehreren Mehrlagenleiterplatten mittels einer Leiterplattenbohrmaschine mit zueinander feststehenden Spindeln, wobei jeder Spindel eine Aufnahmeplatte zugeordnet ist. Die Erfindung betrifft auch eine Vorrichtung zur Durchführung eines Verfahren zum Bohren von mehreren Mehrlagenplatten.

Die europäische Patentanmeldung 0 053 272 A2 zeigt ein Verfahren zum Bohren von einer Mehrlagenleiterplatte mittels einer Leiterplattenbohrmaschine mit einer Spindel, wobei die Aufnahmeplatte der Leiterplattenbohrmaschine in zwei Koordinatenrichtungen relativ zur Spindel verstellbar ist und durch einen Soll-Istvergleich der Versatz der Innenlagen der mehrlagigen Leiterplatte zu der Sollage festgestellt und die Aufnahmeplatte abhängig von Größe und Richtung des Innenlagenversatzes der Leiterplatte bis zum vorgegebenen Sollwert relativ zur Spindel nachgestellt wird.

Diese bisher bekannten Leiterplattenbohrmaschinen sind nicht in der Lage, mehrere Leiterplatten individuell nach den unterschiedlichen Innenlagenverzügen gleichzeitig zu bohren. Aus diesem Grunde können daher mehrspindelige Bohrmaschinen nur einspindelig verwendet werden.

Aufgabe der vorliegenden Erfindung ist es daher, ein Verfahren anzugeben und eine Anordnung zu schaffen, durch die das Bohren von hochlagigen Leiterplatten in rationellerer Weise als bisher ermöglicht wird.

Zur Lösung dieser Aufgabe wird gemäß der Erfindung derart verfahren, daß die Aufnahmeplatten der Leiterplattenbohrmaschine in zwei Koordinatenrichtungen unabhängig voneinander verstellbar sind und durch einen Soll-Istwertvergleich der Versatz der Innenlagen jeder mehrlagigen Leiterplatte zur der Sollage festgestellt und die Aufnahmeplatten abhängig von Größe und Richtung des Innenlagenversatzes der Leiterplatte bis zum vorgegebenen Sollwert nachgestellt wird.

Die Feststellung und Auswertung des Innenlagenversatzes sowie die Nachstellung der Auflagenplatte kann mittels eines Rechners erfolgen.

Die Leiterplattenbohrmaschine zur Durchführung des Verfahrens ist derart ausgebildet, daß die Bohrmaschine mit mehreren nebeneinander angeordneten zueinander feststehenden Bohrspindeln ausgerüstet ist und daß jeder Bohrspindel eine Aufnahmeplatte zugeordnet ist, wobei Mittel vorgesehen sind, durch welche die Aufnahmeplatten unabhängig voneinander verstellbar sind.

Durch diese Maßnahmen wird die Einstellung mehrerer verschiedener Offsetwerte gleichzeitig an einer Maschine ermöglicht, so daß dadurch mehrspindlige Bohrmaschinen verwendet werden können. Dadurch können gleichzeitig mehrere Leiterplatten gebohrt werden, so daß der Flächenbedarf für die Bohrmaschine verringert und die anfallenden Kosten gesenkt werden.

Anhand der Zeichnungen nach den FIG 1 bis 5 wird die Erfindung naher erläutert.
Es zeigen
- FIG 1: eine feststehende Auflageplatte bei einer bekannten einspindeligen Bohrmaschine mit ermittelter Lage der Innenlagenpats,
- FIG 2: ein Maschinentisch nach der Erfindung mit drei verstellbaren Aufnahmeplatten für je eine Mehrlagenleiterplatte und drei Bohrspindeln,
- FIG 3: einen Querschnitt durch eine Leiterplatte an den Bohrtestcoupons,
- FIG 4: ein einzelner Bohrtestcoupon in der Draufsicht,
- FIG 5: eine Anordnung der Bohrtestcoupons am aktiven Rasterfeld.

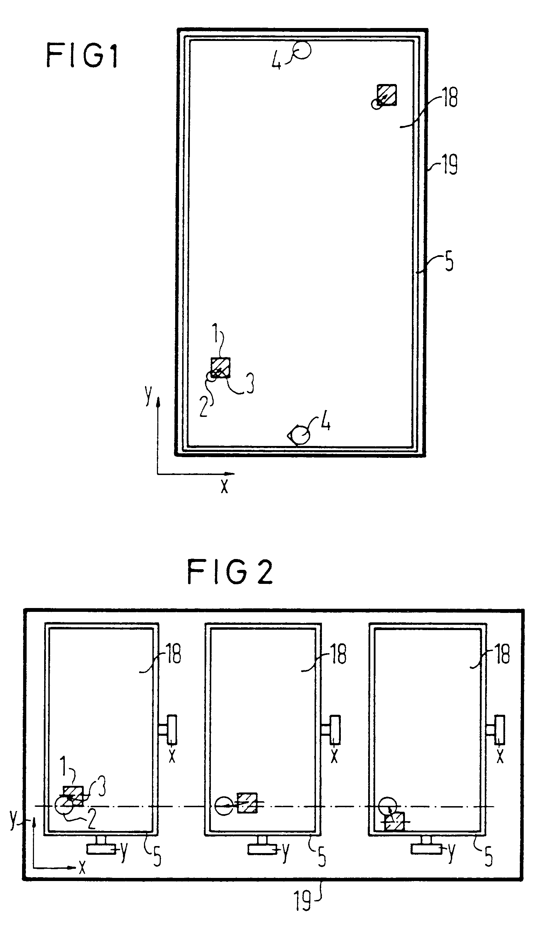

FIG 1 zeigt eine Auflageplatte 5 sowie das Offset des Bohrbildes in X-und Y-Richtung bei einer aufliegenden Leiterplatte 18. Ohne Änderung der nicht dargestellten Bohrspindel oberhalb der Auflageplatte 5, auf der sich eine mehrlagige Leiterplatte 18 befindet, würde die Bohrung 2 exzentrisch gegenüber dem Innenlagenpat 1 erfolgen und damit eine nicht brauchbare Mehrlagenleiterplatte erzeugen. Nach einem später noch zu erläuternden Verfahren wird aber nunmehr der Versatz der Innenlagen gegenüber dem Sollwert ermittelt und eine Verstellung der einzelnen Auflageplatte solange in Richtung des Pfeiles 3 vorgenommen bis sich der Bohrer im Zentrum des Innenlagenpats 1 befindet, anschließend kann der Bohrvorgang vorgenommen werden. Die Bohrung 4 stellt eine Paßbohrung für die Leiterplatte 18 und die Auflageplatte 5 dar.

FIG 2 zeigt den Maschinentisch 19 auf dem sich drei Aufnahmeplatten 5 befinden auf der wiederum die Leiterplatten 18 angeordnet sind. 1 stellt wieder einen Innenpat, 2 die Stellung der Bohrspindeln im Verhältnis zur Lage der Innenpats und 3 den Verstellwert der Aufnahmeplatten dar. Der Vorteil des erfindungsgemäßen Verfahrens liegt wie aus dieser FIG ersichtlich darin, daß man die drei Aufnahmeplatten getrennt voneinander verstellen kann, so daß nunmehr Bohrmaschinen mit mehreren Bohrspindeln verwendet werden können wobei die Bohrspindeln dieser Maschinen unveränderbar zueinander angeordnet sind.

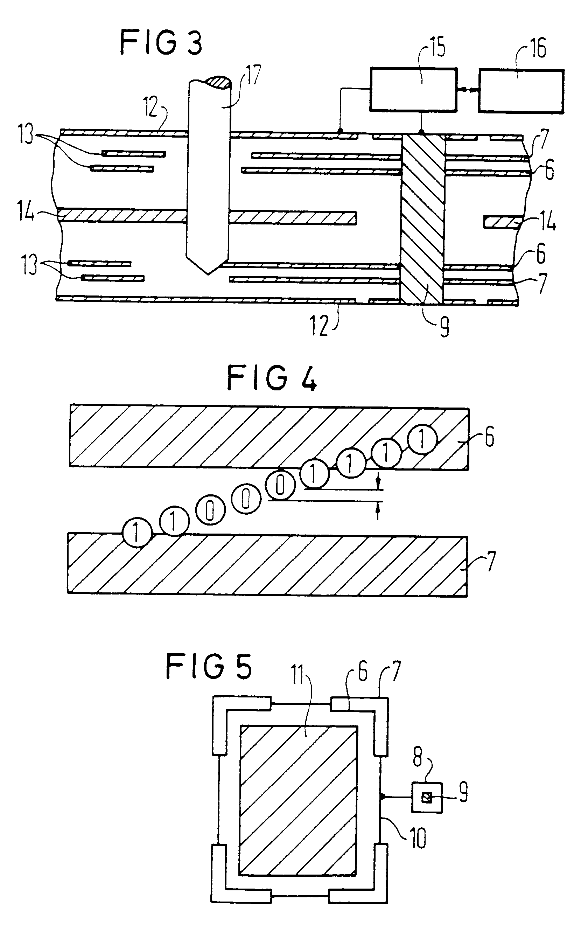

In FIG 3 ist ein Ausschnitt des Querschnitts durch eine Leiterplatte gezeigt, dabei befinden sich am Rande der Leiterplatte sogenannte Bohrtestcoupons 6 und 7, die auf den Innenlagen der Mehrlagenleiterplatte 18 aufgebracht sind sowie die als Innenlagen vorgesehenen Signallagen 13 und Potentiallagen 14. An der Stelle an der sich die Testcoupons befinden ist eine quadratische durchgehende Öffnung durch die Leiterplatte vorgesehen in die ein Einpreßstift 9 eingepreßt wird, der die eine Verbindung zwischen den Außenlagen 12, sowie den Testcouponlagen 6 und 7 herstellt. Zur Prüfung ob Außen- und Innenlagen lagegerecht angeordnet sind, wird nunmehr mit Hilfe eines Bohrers 17 an einer vorgegebenen Stelle eine Prüfbohrung durchgeführt. Trifft der Bohrer auf eine Innenlage eines Testcoupons auf, bricht die zwischen Außenlage 12 der Leiterplatte und Innenlagen 6 und 7 der Bohrtestcoupons angelegte Spannung zusammen, so daß mit Hilfe einer elektrischen Durchgangsmessung festgestellt werden kann, ob der Bohrer in den Innenlagen auf Kupfer trifft oder nicht. Die Auswerteelektronik 15 registriert den Zusammenbruch der Spannung, die zwischen den Außen- und Innenlagen angelegt ist, wenn der Bohrer 17 auf Kupfer auftrifft.

Der Bohrtestcoupon soll nun z.B. so ausgeführt sein, wie in FIG 4 dargestellt. Legt man über diesen Testcoupon eine schräge Lochreihe wie eingezeichnet, erhält man z.B. die Datenkette 11 0001111. Die Datenkette wird von einem Tischrechner, der an die Auswerteelektronik angeschlossen ist, simultan zum Testcoupon-Bohrvorgang erfaßt und ausgewertet. Aus dieser Datenkette und den bekannten Positionen der Testcouponbohrungen läßt sich die Istlage der Testcouponmitte in Bezug auf den Bohrmaschinennullpunkt bestimmen. Bei Verwendung mehrerer Testcoupons wie z.B. in FIG 5 gezeichnet, kann aus den Soll- und Istlagen der Testcoupons auf den Verzug und Versatz des aktiven Rasterfeldes rückgeschlossen werden.

Lineare systematische Fehler des Wegmeßsystems der Bohrmaschine - wie sie z.B. durch Schwankungen der Betriebstemperatur verursacht werden - sind bei Anwendung der Bohrbildoptimierung ohne Einfluß auf die Bohrgenauigkeit.

## Patentansprüche

1. Verfahren zum Bohren von mehrern Mehrlagenleiterplatten mittels einer Leiterplattenbohrmaschine mit zueinander feststehenden Spindeln, wobei jeder Spindel eine Aufnahmeplatte zugeordnet ist, die Aufnahmeplatten (5) der Leiterplattenbohrmaschine in zwei Koordinatenrichtungen unabhängig voneinander verstellbar sind und durch einen Soll-Istwertvergleich der Versatz der Innenlagen (13,14) jeder mehrlagigen Leiterplatte (18) zu der Sollage (12) festgestellt und die Aufnahmeplatten (5) abhängig von Größe und Richtung des Innenlagenversatzes der Leiterplatten (18) bis zum vorgegebenen Sollwert nachgestellt wird.

2. Verfahren nach Anspruch 1, wobei die Feststellung und Auswertung des Innenlagenversatzes, sowie die Nachstellung der Aufnahmeplatten, mittels Rechner (16) erfolgt.

3. Leiterplattenbohrmaschine zur Durchführung des Verfahrens nach einem der Ansprüche 1 oder 2, wobei die Bohrmaschine mit mehreren nebeneinander angeordneten, zueinander feststehenden Bohrspindeln ausgerüstet ist, jeder Bohrspindel eine Aufnahmeplatte (5) zugeordnet ist und wobei Mittel vorgesehen sind, durch welche die Aufnahmeplatten (5) in zwei Koordinatenrichtungen unabhängig voneinander nachstellbar sind.

## Claims

1. Method for drilling a plurality of multilayer circuit boards by means of a printed circuit board drilling machine with spindles which are fixed with respect to one another, each spindle being assigned a mounting plate, the mounting plates (5) of the printed circuit board drilling machine being adjustable independently of each other in two coordinate directions, and the misalignment of the internal layers (13, 14) of each multilayer circuit board (18) with respect to the desired position (12) being determined by a desired-/actual-value comparison, and the mounting plates (5) being readjusted to the given desired value as a function of the magnitude and direction of the internal layer misalignment of the printed circuit boards (18).

2. Method according to Claim 1, the determination and evaluation of the internal layer misalignment as well as the readjustment of the mounting plates being carried out by computer (16).

3. Printed circuit board drilling machine for carrying out the method according to one of Claims 1 or 2, the drilling machine being provided with a plurality of mutually fixed drilling spindles which are arranged side by side, each drilling spindle being assigned a mounting plate (5) and means being provided through which the mounting plates (5) can be readjusted independently of each other in two coordinate directions.

## Revendications

1. Procédé de perçage des plaquettes à circuits imprimés multicouches à l'aide d'une machine à percer les plaquettes à circuits imprimés, comportant des broches fixes les unes par rapport aux autres, chaque broche étant associée une plaque de réception, les plaques de réception (5) de la machine à percer les plaquettes à circuits imprimés pouvant être déplacées indépendamment les unes des autres dans deux directions de coordonnées, et le décalage des positions des couches intérieures (13,14) de chaque plaquette à circuits imprimés multicouches (18) par rapport à la position de consigne (12) étant déterminé par une comparaison valeur de consigne-valeur réelle, et les plaques de réception (5) étant soumises à un réglage en fonction de la grandeur et de la direction du décalage des couches intérieures des plaquettes à circuits imprimés (18), jusqu'à ce que la position de consigne prédéterminée soit atteinte.

2. Procédé suivant la revendication 1, selon lequel la détermination et l'évaluation du décalage des couches intérieures ainsi que le réglage des plaquettes de réception s'effectuent à l'aide d'un ordinateur (16).

3. Machine à percer les plaquettes à circuits imprimés pour la mise en oeuvre du procédé suivant l'une des revendications 1 ou 2, dans laquelle la machine de perçage est équipée de plusieurs broches de perçage disposées côte-à-côte et fixes les unes par rapport aux autres, une plaque de réception (5) étant associée à chaque broche, il est prévu des moyens grâce auxquels les plaques de réception (5) peuvent être réglées indépendamment les unes des autres suivant deux directions de coordonnées
